# EUROPEAN PATENT APPLICATION

(11) **EP 4 621 094 A1**
(43) Date of publication of application: **24.09.2025**
(21) Application number: 25164410.0
(22) Date of filing: 18.03.2025
(51) Int. Cl.: C23C 14/50, C23C 16/458, C30B 25/12, H01L 21/687

(54) **SUSCEPTORS, SEMICONDUCTOR PROCESSINGS SYSTEMS, AND RELATED METHODS**

(30) Priority: 21.03.2024 US 202463568175 P
(71) Applicant: ASM IP Holding B.V., 1322 AP Almere (NL)
(72) Inventor: CHAO, Ion Hong, 1322 AP Almere (NL); GAO, Fan, 1322 AP Almere (NL); WANG, Wentao, 1322 AP Almere (NL); SU, Junwei, 1322 AP Almere (NL); KU, Taison, 1322 AP Almere (NL); PATIL, Kishor, 1322 AP Almere (NL); HERNANDEZ DEL CASTILLO, Ivan, 1322 AP Almere (NL); DEYE, Gregory, 1322 AP Almere (NL); BOPP, Steven, 1322 AP Almere (NL); MISKIN, Caleb, 1322 AP Almere (NL); DEMOS, Alexandros, 1322 AP Almere (NL); SINHA, Shantanu, 1322 AP Almere (NL)
(74) Representative: V.O.

(57) **Abstract**

Susceptors, related systems, and related methods are described. Susceptors according to an embodiment of the present disclosure comprise a plurality of contact knobs. The ones from the plurality of contact knobs may be honed.

## Description

### CROSS-REFERENCE TO RELATED APPLICATIONS

This application claims priority to and the benefits of U.S. Provisional Patent Application Serial No. 63/568,175, filed March 21, 2024, titled SUSCEPTORS, SEMICONDUCTOR PROCESSING SYSTEMS, AND RELATED METHODS, the contents of which is hereby incorporated by reference in its entirety.

### FIELD OF INVENTION

The present disclosure generally relates to fabricating semiconductor devices. More particularly, the present disclosure relates to supporting substrates in semiconductor processing systems during loading and unloading of substrates into and out of process chambers, e.g. process chambers used for the deposition of material layers onto substrates during the fabrication of semiconductor devices.

### BACKGROUND OF THE DISCLOSURE

Semiconductor devices, such as integrated circuits and power electronic semiconductor devices, are commonly formed by depositing material layers onto substrates. Material layer deposition is generally accomplished by loading a substrate into a reaction chamber, heating the substrate, and providing a material layer precursor to the reaction chamber. The reaction chamber typically flows the material layer precursor across the substrate under conditions selected to cause a material layer to deposit onto the substrate. Once the material layer reaches a desired thickness, flow of material layer precursor to the reaction chamber ceases, and the substate is unloaded from the reaction chamber such that the substrate may undergo further processing.

In some deposition operations, accretions may develop within the reaction chamber during the deposition of the material layer on the substrate. For example, the material layer precursor provided to the reaction chamber and/or reaction products may cause accretions to develop on interior surfaces of the reaction chamber walls. The material layer precursor may cause accretions to develop on structures located within the reaction chamber, such as within clearances between structures that are movable relative to one another. And the material layer precursor provided to the reaction chamber may cause accretions to develop between the substrate and the susceptor structure seating the substrate during the deposition process. While generally manageable, accretions on interior surfaces of the reaction chamber walls can complicate temperature control within the reaction chamber, for example, by changing the transmissivity of the reaction chamber walls. Accretions formed within mechanical clearances can reduce reliability by impairing movement of structures, potentially increasing resistance to movement and/or binding. And accretions between the substrate and the susceptor can mechanically fix the substrate to the susceptor, potentially causing damage to reaction chamber components and/or to the substrate itself during unloading subsequent to deposition of the material layer onto the substrate.

Various countermeasures exist to limit the development of accretions within reaction chambers. For example, flow of the material layer precursor may be adjusted to limit accretion development on interior surfaces and structures. A purge gas may be provided to the interior of the reaction chamber to separate the material layer precursor and/or reaction products from interior surfaces and structures. And an etchant may be provided to reaction chamber to etch surfaces and structures prone to accretion development. However, flow pattern adjustments are generally reserved to control material layer thickness profile, purge efficacy may be limited by the tendency of material layer precursor and/or reaction products to diffuse into the purge gas, and etchants may cause damage to the reaction chamber and/or the substrate.

Such systems and methods have generally satisfactory for their intended purpose. However, there remains a need in the art for improved substate supports, semiconductor processing systems, and methods of depositing material layers onto substrates. The present disclosure provides a solution to this need.

### SUMMARY OF THE DISCLOSURE

In some embodiments, described herein is a susceptor, comprising: an annular body extending about a rotation axis and having a plurality of tang portions extending radially inward toward the rotation axis; a disk body with an upper surface seated on the tang portions of the annular body, the disk body having: a first plurality of contact knobs distributed circumferentially about the rotation axis on first circumference C1; a second plurality of contact knobs distributed circumferentially about the rotation on a second circumference C2; and a third plurality of contact knobs distributed circumferentially about the rotation axis on a third circumference C3; wherein the second circumference is radially intermediate the first circumference and the third circumference to limit contact between a substrate seated on the disk body and the upper surface of the disk body.

In some embodiments, (C2-C1)/(C3-C1) equals from at least 0.1 to at most 0.9.

In some embodiments, (C2-C1)/(C3-C1) equals from at least 0.3 to at most 0.7.

In some embodiments, (C2-C1)/(C3-C1) equals from at least 0.2 to at most 0.5.

In some embodiments, (C2-C1)/(C3-C1) equals from at least 0.5 to at most 0.8.

In some embodiments, the first plurality of contact knobs comprises a first surface, the second plurality of contact knobs comprises a second surface, and the third plurality of contact knobs comprise third surface.

In some embodiments, the first surface, the second surface, and the third surface comprise a refractory ceramic.

In some embodiments, the refractory ceramic comprises a semiconductor.

In some embodiments, the semiconductor comprises silicon carbide.

In some embodiments, at least one of the first surface, the second surface, and the third surface is honed.

In some embodiments, at all of the first surface, the second surface, and the third surface are honed.

In some embodiments, at all of the first surface, the second surface, and the third surface are unhoned.

In some embodiments, the first plurality of contact knobs have a first height, wherein the second plurality of contact knobs have a second height, and wherein the third plurality of contact knobs have a third height.

In some embodiments, the first height, the second height, and the third height are equal within a margin of error of 10%.

In some embodiments, the first height is at least 10% greater than at least one of the second height and the third height.

In some embodiments, the second height is at least 10% greater than at least one of the first height and the third height.

In some embodiments, the third height is at least 10% greater than at least one of the second height and the third height.

In some embodiments, the disk body comprises a ceramic coating.

In some embodiments, the susceptor comprises a silicon-containing precoat. The silicon-containing precoat may be formed onto the first plurality of contact knobs. The silicon-containing precoat may be formed onto the second plurality of contact knobs. The silicon-containing precoat may be formed onto the third plurality of contact knobs.

Further described herein is an apparatus for processing a substrate, the apparatus comprising: a processing chamber configured to accommodate a substrate; and a susceptor disposed in the processing chamber and configured to support the substrate, the susceptor comprising an annular body extending about a rotation axis and having a plurality of tang portions extending radially inward toward the rotation axis; a disk body with an upper surface seated on the tang portions of the annular body, the disk body having: a first plurality of contact knobs distributed circumferentially about the rotation axis on first circumference C1; a second plurality of contact knobs distributed circumferentially about the rotation on a second circumference C2; and a third plurality of contact knobs distributed circumferentially about the rotation axis on a third circumference C3; wherein the second circumference is radially intermediate the first circumference and the third circumference to limit contact between a substrate seated on the disk body and the upper surface of the disk body.

Further described herein is a method of forming an epitaxial layer, the method comprising providing an apparatus comprising: a processing chamber configured to accommodate a substrate; and a susceptor configured to support the substrate, the susceptor comprising an annular body extending about a rotation axis and having a plurality of tang portions extending radially inward toward the rotation axis; a disk body with an upper surface seated on the tang portions of the annular body, the disk body having: a first plurality of contact knobs distributed circumferentially about the rotation axis on first circumference C1; a second plurality of contact knobs distributed circumferentially about the rotation on a second circumference C2; and a third plurality of contact knobs distributed circumferentially about the rotation axis on a third circumference C3; wherein the second circumference is radially intermediate the first circumference and the third circumference to limit contact between a substrate seated on the disk body and the upper surface of the disk body; placing the substrate on the susceptor, the substrate comprising a monocrystalline surface; contacting the substrate with one or more process gases while the substrate is in the processing chamber; forming the epitaxial layer on the monocrystalline surface; wherein during at least one of placing the substrate on the susceptor, contacting the substrate with one or more process gases, and forming the epitaxial layer onto the substrate bows and is supported by at least one of the first plurality of contact knobs, the second plurality of contact knobs, and the third plurality of contact knobs; and whereby the supporting the substrate on one or more of the first plurality of contact knobs, the second plurality of contact knobs, and the third plurality of contact knobs limits contact between the substrate and the upper surface of the disk body.

In some embodiments, the method comprises transporting the substrate into the processing chamber.

In some embodiments, the method comprises transporting the substrate out of the processing chamber.

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE DRAWING FIGURES

Fig. 1 shows a susceptor 100 in accordance with an embodiment of the present disclosure.
Fig. 2 illustrates a gas delivery arrangement 12.
Fig. 3 illustrates a chamber arrangement 14.
Fig. 4 illustrates an exemplary susceptor 400.
Fig. 5 shows a cross section of a susceptor 400 according to an embodiment of the present disclosure.
Fig. 6 shows how damage to a silicon wafer can be avoided by employing a susceptor comprising honed contact knobs.
Fig. 7 shows a material layer being deposited on a wafer supported on a susceptor.
Fig. 8 shows a bent substrate 820 on a susceptor 810 according to an embodiment of the present disclosure.
Fig. 9 shows an embodiment of a susceptor 900.
Fig. 10 shows cross sections of contact knobs 1001,1002,1003 in accordance with embodiments of the present disclosure.
Fig. 11 illustrates a method according to an embodiment of the present disclosure.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

As used herein, a "substrate" refers to any material having a surface onto which material can be deposited. A substrate may include a bulk material, such as semiconductor material like silicon (e.g., single crystal silicon). A substrate may include a wafer, such as 300-millimeter wafer, and may be formed from a semiconductor material such as silicon. A substrate may include one or more layers overlaying the bulk material. The one or more layers overlaying the bulk material may include a pattern including various topologies such as trenches, vias, lines, and the like formed within or on the material layer.

The illustrations presented herein are not meant to be actual views of any particular material, structure, or device, but are merely idealized representations that are used to describe embodiments of the disclosure.

The particular implementations shown and described are illustrative of the invention and its best mode and are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

The terminology used herein is for the purpose of describing particular embodiments only and is not intended to be limiting of the present disclosure. As used herein, the singular forms "a", "an", and "the" are intended to include the plural forms as well, unless the context clearly indicates otherwise. It will be further understood that the terms "comprises" and/or "comprising", when used in this specification, specify the presence of stated features, integers, steps, operations, elements, and/or components, but do not preclude the presence or addition of one or more other features, integers, steps, operations, element components, and/or groups thereof.

The term "about" is intended to include the degree of error associated with measurement of the particular quantity based upon the equipment available at the time of filing the application. For example, "about" can include a range of .+-.8% or 5%, or 2% of a given value, or variations thereon based on the technology and concepts involved with a particular value or range, and as understood by those of skill in the particular art. Additionally, the term "exemplary" is used herein to mean "serving as an example, instance or illustration." Any embodiment or design described herein as "exemplary" is not necessarily to be construed as preferred or advantageous over other embodiments or designs. The terms "at least one" and "one or more" are understood to include any integer number greater than or equal to one, i.e., one, two, three, four, etc. The term "a plurality" is understood to include any integer number greater than or equal to two, i.e., two, three, four, five, etc. The term "connection" can include an indirect "connection" and a direct "connection".

In some embodiments, "unhoned" can mean one or more of "not honed", "pristine", "native", and "as deposited".

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present disclosure includes all novel and nonobvious combinations and subcombinations of the various processes, systems, and configurations, and other features, functions, acts, and/or properties disclosed herein, as well as any and all equivalents thereof.

Described herein are susceptors, related apparatuses, and related methods.

An apparatus according to an embodiment of the present disclosure can be employed for processing a substrate and comprises a processing chamber configured to accommodate a substrate and a susceptor as described herein. The susceptor or a part thereof can be disposed in the processing chamber and can be configured to support the substrate, e.g. during at least one of loading, processing, and unloading of the substrate. Such an embodiment of an apparatus can be employed for processing a substrate, e.g. for forming a layer such as an epitaxial layer on a substrate. An exemplary method can comprise placing a substrate that comprises a surface, e.g. a monocrystalline surface, on the susceptor. The method can further comprise contacting the substrate with one or more process gases. Thus the layer, e.g. the epitaxial layer, can be formed on the surface. It shall be understood that exemplary processes for forming layers, such as epitaxial layers, are as such known in the art.

In addition to one or more of the features described above, or as an alternative, depositing the material layer may include heating the substrate to a material layer deposition temperature that is between about 500 degrees Celsius and about 1200 degrees Celsius, or between about 700 degrees Celsius and about 1200 degrees Celsius, or between about 900 degrees Celsius and about 1200 degrees Celsius.

In additional to one or more of the features described above, or as an alternative, depositing the material layer may include pressurizing an interior of a chamber body housing the susceptor to a deposition pressure that is between about 1 torr and about 760 torr, or between about 20 torr and about 760 torr, or between about 50 torr and about 760 torr.

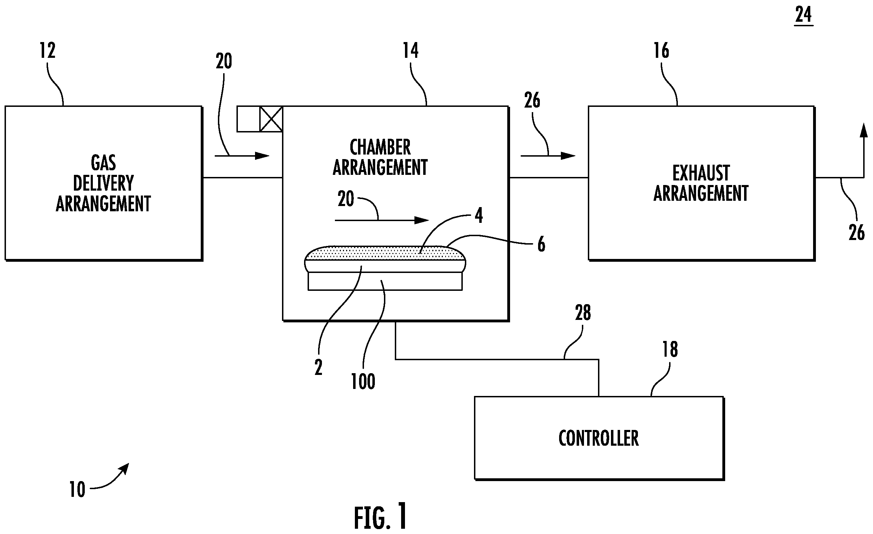

Reference will now be made to the drawings wherein like reference numerals identify similar structural features or aspects of the subject disclosure. For purposes of explanation and illustration, and not limitation, a partial view of an example of a susceptor 100 in accordance with an embodiment of the present disclosure is shown in FIG. 1. The systems and methods of the present disclosure may be used for depositing material layers onto substrates during the fabrication of semiconductor devices, such as at least one of before, during, and after the deposition of thick epitaxial films onto substrates to fabricate power electronic devices, though the present disclosure is not limited to the fabrication of power electronic devices or to the deposition of any particular type of material layer in general.

Referring to FIG. 1, a semiconductor processing system 10 is shown. The semiconductor processing system 10 includes a gas delivery arrangement 12 and a chamber arrangement 14 including the susceptor 100. The semiconductor processing system 10 also includes an exhaust arrangement 16 and a controller 18. Although a particular arrangement of the semiconductor processing system 10 is shown and described herein, it is to be understood and appreciated that semiconductor processing systems having other arrangements can also benefit from the present disclosure.

The gas delivery arrangement 12 is connected to the chamber arrangement 14 and is configured to provide a material layer process gas 20 to the chamber arrangement 14. The chamber arrangement 14 houses the susceptor 100, fluidly couples the susceptor 100 to the gas delivery arrangement 12 to receive the material layer process gas 20 from the gas delivery arrangement 12, and is configured to provide the material layer process gas 20 to the top surface 6 of the substrate 2. The exhaust arrangement 16 is connected to the chamber arrangement 14, is fluidly coupled to the susceptor 100, and is configured to communicate a flow of residual material layer precursor and/or reaction products 26 issued by the chamber arrangement 14 to an external environment 24 outside of the semiconductor processing system 10. The controller 18 is operatively connected to the semiconductor processing system 10 and is configured to control deposition of the material layer 4 onto the top surface 6 of the substrate 2. In certain examples, the material layer 4 may be an epitaxial material layer. The material layer 4 may include (e.g., comprise, include, consist of, or consist essentially of) silicon. The material layer 4 may be a thick epitaxial layer. The material layer 4 may have a thickness that is between about 40 microns and about 100 microns, or between about 60 microns and about 100 microns, or even between about 80 microns and about 100 microns.

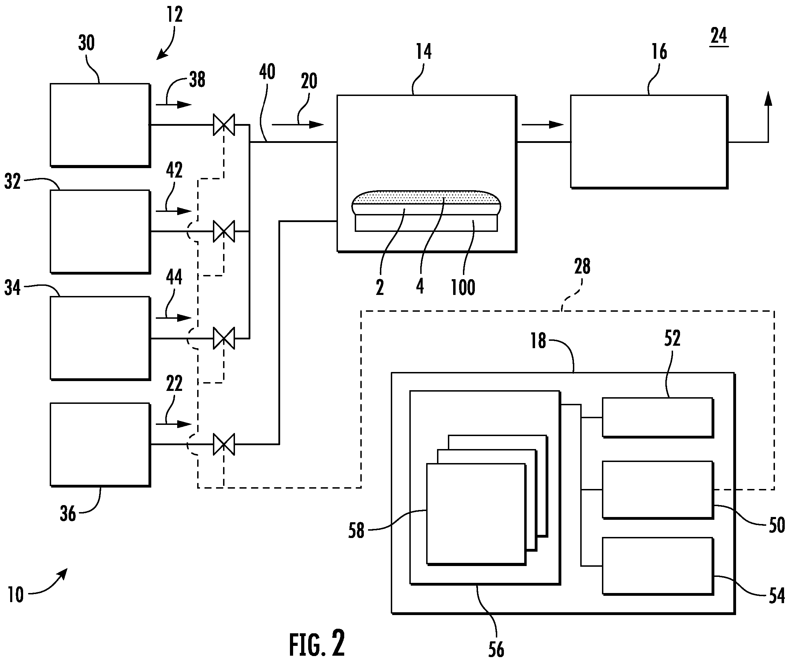

With reference to FIG. 2, the gas delivery arrangement 12 is illustrated. The gas delivery arrangement 12 includes a first precursor source 30, a optional second precursor source 32, and carrier/purge gas source 34, and an optional further source 36. The first precursor source 30 is coupled to the chamber arrangement 14 by a precursor conduit 40 and is configured to provide a first precursor 38 to the chamber arrangement 14. In certain examples, the first precursor source 30 may be further coupled to the chamber arrangement 14 by a first precursor valve. The first precursor valve may include a manual actuator, a pneumatic actuator, or an electrical actuator such a solenoid. The first precursor valve may be operatively associated with a controller, such as the controller 18. The first precursor valve may be incorporated in a flow control device, such as a first precursor mass flow controller (MFC) device. In accordance with certain examples, the first precursor 38 may include a silicon-containing precursor. Non-limiting examples of suitable silicon-containing precursor include silane (SiH₄) and halosilanes, e.g. chlorosilanes such as dichlorosilane (H₂SiCl₂), and trichlorosilane (HCl₃Si).

The optional second precursor source 32 is coupled to the chamber arrangement 14 by the precursor conduit 40 and may be configured to provide a second precursor 42 to the chamber arrangement 14. In certain examples, the optional second precursor source 32 may be further coupled to the chamber arrangement 14 by a second precursor valve. The second precursor valve may include a manual actuator, a pneumatic actuator, or an electrical actuator. The second precursor valve may be operatively associated with a controller, such as the controller 18. The second precursor valve may be incorporated in a flow control device, such as a second precursor MFC device. In accordance with certain examples, the second precursor 42 may include a dopant or alloying constituent. Non-limiting examples of suitable dopant or alloying constituents include germanium (Ge), arsenic (As), phosphorous (P), and/or boron (B).

The carrier/purge gas source 34 is connected to the chamber arrangement 14 by the precursor conduit 40 and is configured to provide a carrier/purge gas 44 to the chamber arrangement 14. In certain examples, the carrier/purge gas source 34 may be coupled to the chamber arrangement 14 by a carrier/purge gas valve. The carrier/purge gas valve may include a manual actuator, an electrical actuator, or a pneumatic actuator. The carrier/purge gas valve may be operatively associated with a controller, such as the controller 18. The carrier/purge gas valve may be incorporated in a flow control device, such as a carrier/purge gas MFC device. In accordance with certain examples, the carrier/purge gas 44 may include hydrogen (H₂) gas. It is also contemplated that the carrier/purge gas 44 may include an inert gas. Non-limiting examples of suitable inert gases include nitrogen (N₂) gas, argon (Ar) gas, helium (He) gas, mixtures thereof.

The optional further source 36 can be connected to the chamber arrangement 14 by an optional further conduit and may be configured to provide a further gas 22 to the chamber arrangement 14. In certain examples, the optional further source 36 may be coupled to the chamber arrangement 14 by an further gas valve. The further gas valve may include a manual actuator, an electrical actuator, or a pneumatic actuator. The further gas valve may be operatively associated with a controller, such as the controller 18. The further gas valve may be incorporated in a flow control device, such as an etchant MFC device. In accordance with certain examples, the optional further source 36 may further be connected to the chamber arrangement 14 by the precursor conduit 40.

The controller 18 includes a device interface 50, a processor 52, a user interface 54, and a memory 56. The device interface 50 is connected the wired or wireless link 28 and is coupled therethrough to one or more of the gas delivery arrangement 12, the chamber arrangement 14, and the exhaust arrangement 16. The processor 52 is connected to the device interface 50, is operatively connected to the user interface 54 provide and receive therethrough user output and user input and is disposed in communication with the memory 56. The memory 56 includes a non-transitory machine-readable medium. The non-transitory machine-readable medium has a plurality of program modules 58 recorded in the medium that, when read by the processor 52, cause the processor 52 to execute certain operations. Among the operations are operations of a material layer deposition method as described herein. Although the gas delivery arrangement 12 and the controller 18 are shown and described herein as having particular arrangements, it is to be understood and appreciated that semiconductor processing systems having gas delivery arrangements and/or controllers with different arrangements may also benefit from the present disclosure.

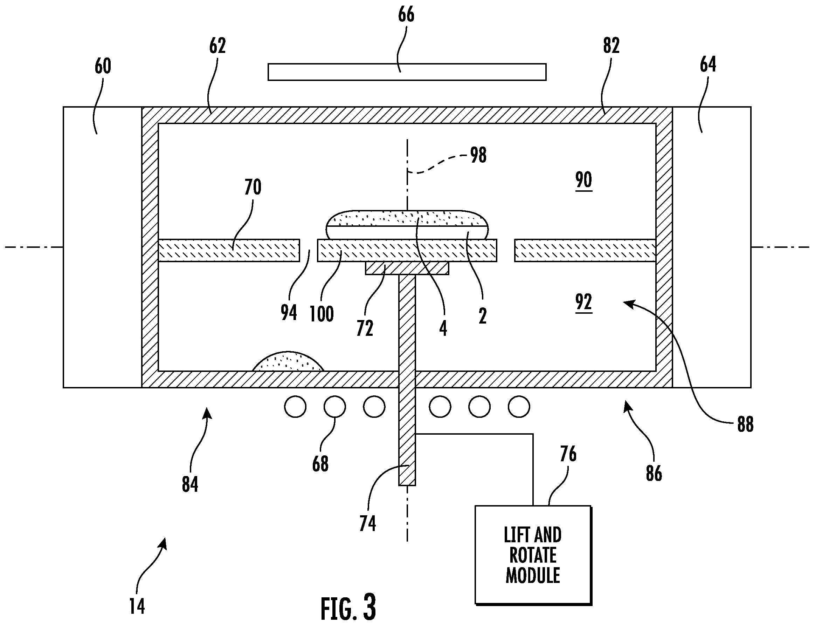

With reference to FIG. 3, the chamber arrangement 14 is shown. The chamber arrangement 14 includes an injection flange 60, a chamber body 62, and an exhaust flange 64. The chamber arrangement 14 also includes an upper lamp array 66, a lower lamp array 68, and a divider 70. The chamber arrangement 14 further includes a support member 72, a shaft member 74, and a lift and rotate module 76. Although a particular arrangement of the chamber arrangement 14 is shown and described herein, it is to be understood and appreciated that the chamber arrangements having other arrangement may also benefit from the present disclosure.

The chamber body 62 is formed from a transparent material 82 and has an injection end 84 and a longitudinally opposite (relative to a general direction of fluid flow through the chamber body 62) exhaust end 86. The chamber body 62 also has an interior 88, which is hollow. The injection flange 60 is connected to the injection end 84 of the chamber body 62 and fluidly couples the gas delivery arrangement 12 (shown in FIG. 1) to the interior 88 of the chamber body 62. The exhaust flange 64 is connected to the exhaust end 86 of the chamber body 62 and is fluidly coupled to the interior 88 of the chamber body 62. It is contemplated that the exhaust flange 64 fluidly couple the interior 88 of the chamber body 62, and therethrough the gas delivery arrangement 12, to the exhaust arrangement 16 (shown in FIG. 1). In certain examples, the transparent material 82 forming the chamber body 62 may be ceramic material. Examples of suitable transparent materials include quartz.

The upper lamp array 66 is supported above the chamber body 62 and is configured to heat the substrate 2 while seated on the susceptor 100. In certain examples the upper lamp array 66 may include one or more linear lamp. The upper lamp array 66 may include a filament-type lamp. The upper lamp array 66 may include one or more linear lamp extending longitudinally above the chamber body 62 between the injection end 84 and the exhaust end 86 of the chamber body 62. In accordance with certain examples, the upper lamp array 66 may include a plurality of linear lamps. The plurality of linear lamps may be laterally spaced apart from one another between the longitudinally opposite injection end 84 and the exhaust end 86 of the chamber body 62. The plurality of linear lamps may extend laterally across the chamber body 62 between laterally opposite sides of the chamber body 62.

The lower lamp array 68 is similar to the upper lamp array 66 and is additionally supported below the chamber body 62. In certain examples, the lower lamp array 68 may include one or more linear lamp. The one it more linear lamp may be substantially orthogonal to the one or more linear lamp of the upper lamp array 66. In accordance with certain examples, the lower lamp array 68 may include one or more spot lamp. The one or more spot lamp may be oriented upwards towards the chamber body 62. The one or more spot lamp may be offset from the rotation axis 98 and oblique relative to the rotation axis 98.

The divider 70 is seated within the interior 88 of the chamber body 62 and divides the interior 88 into an upper chamber 90 (relative to gravity) and a lower chamber 92. It is contemplated that the divider 70 has a divider aperture 94. The divider aperture 94 extends through a thickness of the divider 70 and fluidly couples an upper surface of the divider 70 to a lower surface of the divider 70. The divider aperture 94 further couples the upper chamber 90 to the lower chamber 92 of the chamber body 62. In certain examples, the divider 70 may be formed from an opaque material 96. The opaque material 96 may have a transmissivity to electromagnetic radiation within wavelengths emitted by the upper lamp array 66 and/or the lower lamp array 68 that is lower than a transmissivity of the transparent material 82 forming the chamber body 62. Non-limiting examples of suitable opaque materials include graphite and pyrolytic carbon materials. In accordance with certain examples, the divider 70 may be encapsulated (at least partially) with a coating. Non-limiting examples of suitable coatings include ceramic coatings, such silicon carbide (SiC) coatings.

The susceptor 100 is configured to support substrates during at least one of transporting the substrate and during the deposition of material layers onto the substrate, e.g., the substrate 2 (shown in FIG. 1) during deposition of the material layer 4 onto the substrate 2. In this respect it is contemplated that the susceptor 100 be arranged within the interior 88 of the chamber body 62 and supported for rotation R about a rotation axis 98 relative to the chamber body 62. More specifically, the susceptor 100 is arranged within the divider aperture 95 and is supported within (at least partially) the divider aperture 94 for rotation R about the rotation axis 98 relative to the chamber body 62. It is further contemplated that the susceptor 100 be operably associated with the lift and rotate module 76. In the illustrated example the susceptor 100 is coupled to the lift and rotate module 76 by the support member 72 and the shaft member 74, the support member 72 arranged within the lower chamber 92 and fixed in rotation relative to the susceptor 100, the shaft member 74 fixed in rotation relative to the support member 72 and extending through a lower wall of the chamber body 62 for operable association with the lift and rotate module 76 in the external environment 24. The support member 72 and/or the shaft member 74 may be formed from a transparent material. Examples of suitable transparent materials include quartz. As will be appreciated by those of skill in the art in view of the present disclosure, the susceptor 100 may be supported with a different support arrangement in other examples and remain within the scope of the present disclosure.

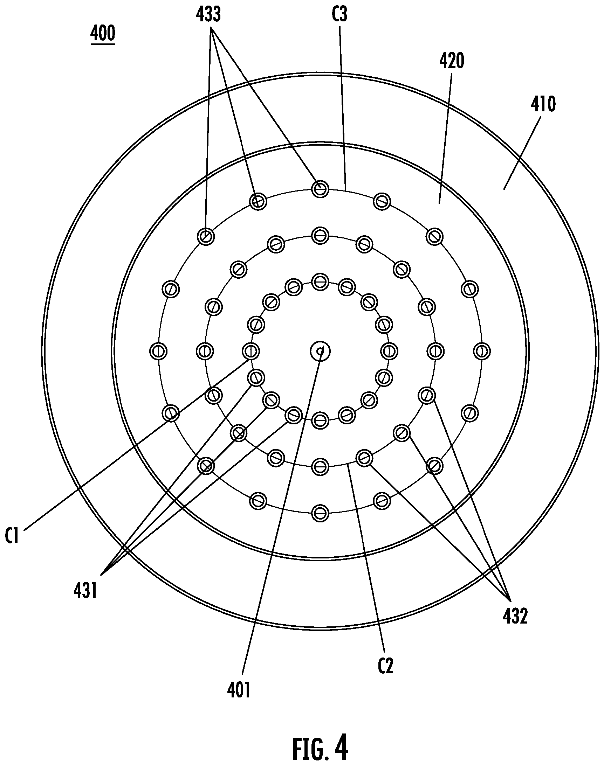

An exemplary susceptor 400 is discussed with reference to Fig. 4, which shows a top view of a susceptor 400 according to an embodiment of the present disclosure. The susceptor 400 comprises an annular body 410 and a disk body 420. The annular body 410 may extend about a rotation axis 401 as described herein. The annular body may comprise a plurality of tang portions (shown elsewhere) that extend radially inward toward the rotation axis.

The disk body 420 comprises is seated on the tang portions 421 of the annular body 410. The disk body comprises an upper surface. The disk body 420 comprises a first plurality of contact knobs 431 distributed circumferentially about the rotation axis on a first circumference C1. The disk body 420 further comprises a second plurality of contact knobs 432 distributed circumferentially about the rotation on a second circumference C2. The disk body 420 further comprises a third plurality of contact knobs 433 distributed circumferentially about the rotation axis on a third circumference C3. The second circumference C2 is radially intermediate the first circumference C1 and the third circumference C3 to limit contact between a substrate seated on the disk body 420 and the upper surface of the disk body. Thus, damage to the substrate can be limited or avoided.

For example, one or more contact knobs can be positioned on the first circumference C1. The first circumference can have a radius of at least 0 mm to at most 20 mm. Contact knobs at the first circumference can have a height which is higher than 0 mm and lower than 0.3 mm.

For example, 6 or more contact knobs can be positioned on the second circumference C2 . The second circumference can have a radius of at least 80 mm to at most 100 mm. Contact knobs at the second circumference can have a height which is higher than 0 mm and lower than 0.3 mm.

For example, 6 or more contact knobs can be positioned on the third circumference C3 . The third circumference can have a radius of at least 240 mm to at most 270 mm. Contact knobs at the second circumference can have a height which is higher than 0 mm and lower than 0.3 mm.

Of course, other arrangements of contact knobs are possible as well. For example, the contact knobs may be present in a lattice, such as a simple square lattice, or a triangular lattice, or a face-centered square lattice, or a hexagonal lattice.

Any suitable number of contact knobs can be positioned on the first circumference C1. For example, from at least 1 to at most 20 contact knobs can be positioned on the first circumference, or from at least 2 to at most 5 contact knobs can be positioned on the first circumference, or from at least 5 to at most 10 contact knobs can be positioned on the first circumference, or from at least 10 to at most 20 contact knobs can be positioned on the first circumference.

Any suitable number of contact knobs can be positioned on the second circumference C2. For example, from at least 1 to at most 20 contact knobs can be positioned on the second circumference, or from at least 2 to at most 5 contact knobs can be positioned on the second circumference, or from at least 5 to at most 10 contact knobs can be positioned on the second circumference, or from at least 10 to at most 20 contact knobs can be positioned on the second circumference.

Any suitable number of contact knobs can be positioned on the third circumference C3. For example, from at least 1 to at most 20 contact knobs can be positioned on the third circumference, or from at least 2 to at most 5 contact knobs can be positioned on the third circumference, or from at least 5 to at most 10 contact knobs can be positioned on the third circumference, or from at least 10 to at most 20 contact knobs can be positioned on the third circumference.

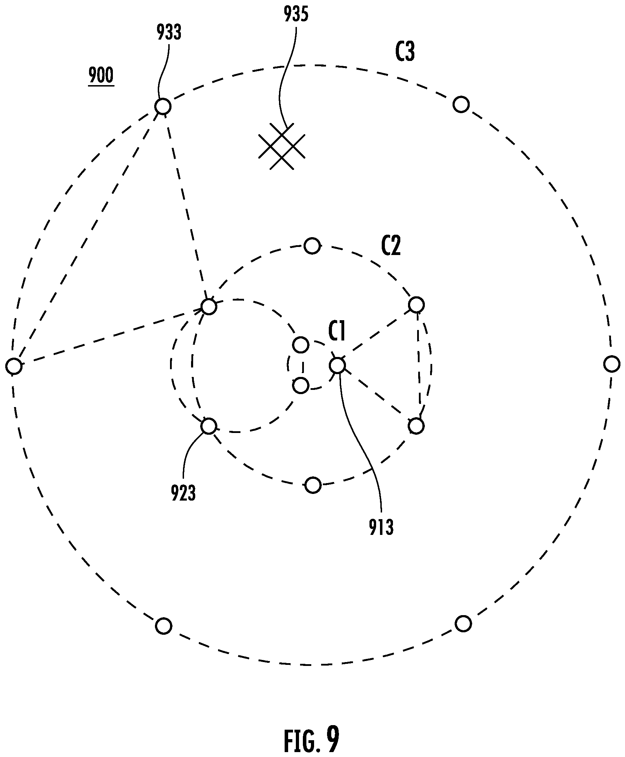

In some embodiments, and referring to Fig. 9, three contact knobs 913 can be positioned on the first circumference, six contact knobs 923 can be positioned on the second circumference, and six contact knobs 933 can be positioned on the third circumference. Such a susceptor 900 can stably support a substrate while minimizing or avoiding damage, hot spots, cold spots, and the like.

In some embodiments, the contact knobs 913 on the first circumference can be evenly spaced, i.e. they can be positioned at equal distances on radial lines which are at uniform angles apart. For example, there can be three contact knobs 913 on the first circumference which are spaced on radial lines which are 120 degrees apart.

In some embodiments, the contact knobs 923 on the second circumference can be evenly spaced, i.e. they can be positioned at equal distances on radial lines which are at uniform angles apart. For example, there can be six contact knobs 923 on the second circumference which are spaced on radial lines which are 60 degrees apart.

In some embodiments, the contact knobs 933 on the third circumference can be evenly spaced, i.e. they can be positioned at equal distances on radial lines which are at uniform angles apart. For example, there can be six contact knobs 933 on the third circumference which are spaced on radial lines which are 60 degrees apart.

In some embodiments, and as shown in Fig. 9, two contact knobs on 933 on the third circumference and one contact knob 923 on the second circumference are positioned on the corners of an equilateral triangle.

In some embodiments, and as shown in Fig. 9, two contact knobs on 923 on the second circumference and one contact knob 913 on the first circumference are positioned on the corners of an equilateral triangle.

In some embodiments, a silicon-containing precoat 935 may be formed onto the susceptor, for example the susceptor 900. For example, the silicon-containing precoat 935 may be formed onto the first plurality of contact knobs 913, the second plurality of contact knobs 923, and the third plurality of contact knobs 933.

In some embodiments, the silicon-containing precoat 932 may be between about 500 nanometers and about 5 microns, or between about 500 nanometers and about 3 microns, or even between about 500 nanometers and about 1.5 microns. Advantageously, such silicon-containing precoats may (either or both) separate relatively jagged surfaces (such as a silicon carbide deposit) located on the susceptor surface and/or the contact knobs on the susceptor surface from the backside of a wafer or susceptor seated on the susceptor, limiting (or eliminating) damage potentially cause by contact of the wafer or substrate with the jagged surface.

Advantageously, a susceptor according to an embodiment of the present disclosure allows properly supporting substrate in a stable fashion with as few contact knobs as possible. This can minimize substrate damage. To further advantage, forming the silicon-containing precoat 935 onto the susceptor may limit tolerance (e.g., open a tolerance to be amenable to additional variation) of a honing process employed to hone surfaces the plurality of contact knows formed on the susceptor, simplifying manufacture of the susceptor.

The contact knobs 431, 432, 433 can be positioned at any suitable position. Thus, various relative positions of the first circumference C1, the second circumference C2, and the third circumference C3 are possible. In some embodiments, (C2-C1)/(C3-C1) equals from at least 0.1 to at most 0.9. In some embodiments, (C2-C1)/(C3-C1) equals from at least 0.2 to at most 0.8. In some embodiments, (C2-C1)/(C3-C1) equals from at least 0.3 to at most 0.7. In some embodiments, (C2-C1)/(C3-C1) equals from at least 0.4 to at most 0.6. In some embodiments, (C2-C1)/(C3-C1) equals from at least 0.2 to at most 0.5. In some embodiments, (C2-C1)/(C3-C1) equals from at least 0.3 to at most 0.4. In some embodiments, (C2-C1)/(C3-C1) equals from at least 0.5 to at most 0.8. In some embodiments, (C2-C1)/(C3-C1) equals from at least 0.5 to at most 0.9. In some embodiments, (C2-C1)/(C3-C1) equals from at least 0.6 to at most 0.7.

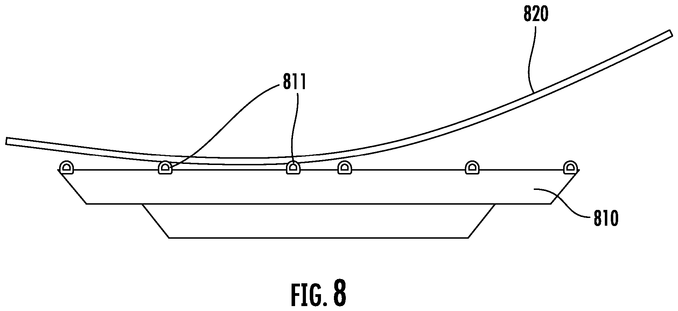

Fig. 8 illustrates how contact knobs 811 can minimize contact area between a bent substrate 820, e.g. wafer, and a susceptor 810.

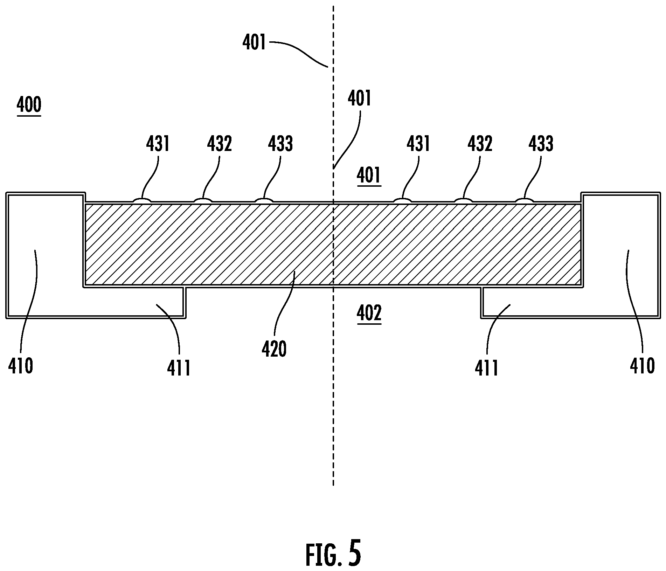

Fig. 5 shows a cross section of the susceptor 400 according to an embodiment of the present disclosure which has already been discussed with reference to Fig. 4. The susceptor 400 extends about a rotation axis 401 and comprises the aforementioned annular body 410 and disk body 420. The disk body 420 is seated on tang portions 411 comprised in the annular body 410.

A disk body 420 according to an embodiment of the present disclosure can have a front side 402 and a back side 403. The back side 403 can be in contact with the tang portions. The front side 402 can comprise the contact knobs 431,432,433.

In some embodiments, the first plurality of contact knobs comprises a first surface, the second plurality of contact knobs comprises a second surface, and the third plurality of contact knobs comprise third surface.

In some embodiments, at least one of the first surface, the second surface, and the third surface is honed. In some embodiments, all of the first surface, the second surface, and the third surface are honed. In some embodiments, all of the first surface, the second surface, and the third surface are unhoned. In some embodiments, the first surface is honed and the second and third surfaces are unhoned. In some embodiments, the second surface is honed and the first and third surfaces are unhoned. In some embodiments, the third surface is honed and the first and second surfaces are unhoned. In some embodiments, the first and second surfaces are honed and the third surface is unhoned. In some embodiments, the first and third surfaces are honed and the second surface is unhoned. In some embodiments. The second and third surfaces are honed and the first surface is unhoned.

In some embodiments, one or more of the first, second, and third surfaces can be polished. This notwithstanding, honed contact knobs can be preferable over polished contact knobs. Indeed, substrates on susceptors with honed contact knobs exhibit superior friction compared to substrates on susceptors with polished contact knobs. Compared to susceptors with as-formed, i.e. unhoned, contact knobs, susceptors with honed contact knobs cause less substrate damage. Thus, contact knobs of susceptors according to embodiments of the present disclosure are preferably honed.

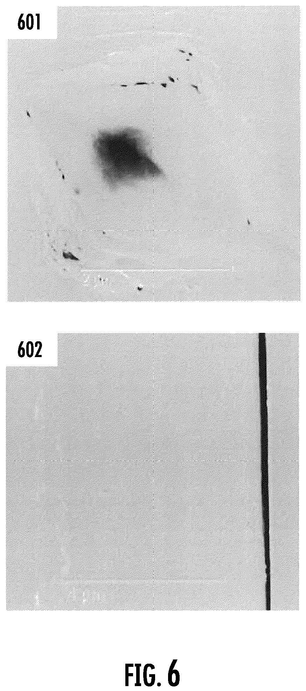

Fig. 6 shows how damage to a substrate, particularly to a silicon wafer, can be avoided by employing a susceptor comprising honed contact knobs according to an embodiment of the present disclosure that particularly comprises a honed surface, such as a honed silicon carbide surface. In particular, severe substrate damage 601 comprising an indentation is shown, which is caused by contact knobs with an unhoned silicon carbide surface that comprises damage-causing sharp crystallites. Employing honed contact knobs causes less severe substrate damage 602; particularly only minor scratches. This correlates with sharp crystallite features being removed from a honed silicon carbide surface. Without being bound by a particular theory or mode of operation, it is believe that the honed silicon carbide surface may limit size backside scratches or nodules such as shown at 601, limiting the tendency of such features to cause slip-line (e.g., crystalline) defects that may otherwise tend to propagate through the bulk material forming the material layer deposited onto the substrate. The reduced tendency of such defects to otherwise induce such slip-line defects enables the employment of higher load and/or unload temperatures, such as between about 650 degrees Celsius and about 750 degrees Celsius instead of between about 500 degrees Celsius and about 600 degrees Celsius. Advantageously, higher load and/or unload temperatures enables greater throughput than otherwise possible.

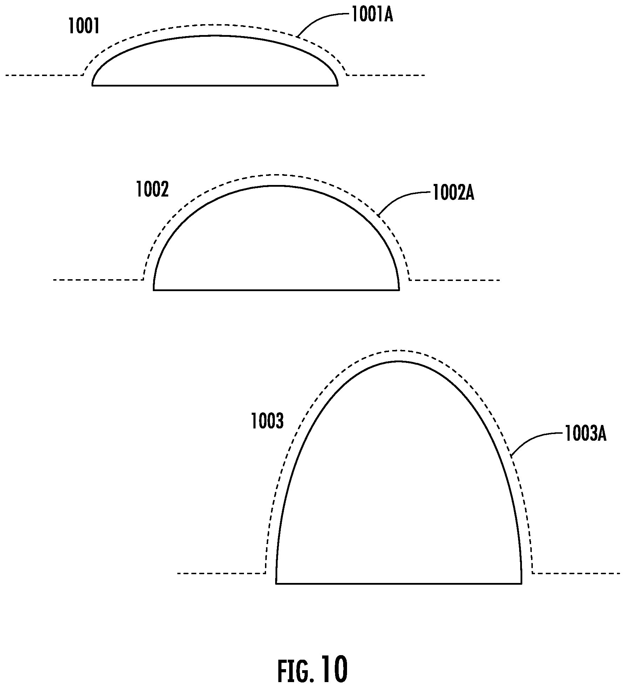

In some embodiments, contact knobs comprised in a susceptor according to an embodiment according to the present disclosure have an arcuate surface. In some embodiments, the contact knobs have a convex surface. For example, the contact knobs can have a hemispherical, paraboloid, or geode-shaped surface. Exemplary cross sections of contact knobs 1001,1002,1003 are shown in Fig. 10.

In some embodiments, the disk body comprises a ceramic coating, for example a ceramic coating 1001A, a ceramic coating 1002A, and/or a ceramic coating 1003A. For example, the ceramic coating can comprise a refractory ceramic.

In some embodiments, the contact knobs comprise, e.g. are covered by, the ceramic coating.

In some embodiments, at least one of the first surface, the second surface, and the third surface comprise a refractory ceramic. In some embodiments, the first surface, the second surface, and the third surface comprise a refractory ceramic. In some embodiments, the first surface comprises a refractory ceramic. In some embodiments, the second surface comprises a refractory ceramic. In some embodiments, the third surface comprises a refractory ceramic.

In some embodiments, the refractory ceramic comprises a semiconductor. In some embodiments, the refractory ceramic comprises a compound semiconductor. In some embodiments, the refractory ceramic comprises a polycrystalline semiconductor.

In some embodiments, the refractory ceramic comprises silicon carbide.

In some embodiments, a silicon-containing precoat may overlie the ceramic coating.

In some embodiments, a susceptor as described herein may include that the disk body is defined by a bulk graphite material. The bulk graphite material may be encapsulated by a coating. The coating may be a silicon carbide coating.

In some embodiments, the first plurality of contact knobs have a first height, the second plurality of contact knobs have a second height, and the third plurality of contact knobs have a third height. Height of contact knobs can refer to the characteristic size of contact knobs in the direction of the susceptor's rotational axis.

In some embodiments, ones from the first plurality of contact knobs have the same height. In some embodiments, ones from the second plurality of contact knobs have the same height. In some embodiments, ones from the third plurality of contact knobs have the same height.

It shall be understood that the expression "the same height" can indicate an equal height within a certain margin of error, for example within a margin of error of 10, 5, 2, 1, 0.5, 0.2, or 0.1 percent.

In some embodiments, the first height, the second height, and the third height are equal within a margin of error of 10, 5, 2, 1, 0.5, 0.2, or 0.1 percent.

In some embodiments, the first height is at least 10% greater than at least one of the second height and the third height, such as 20, 30, 40, or 50 percent greater. The second height and the third height may be equal. Alternatively, the second height and the third height may be different, for example the second height may be lower than the first height, such as from at least 10% to at most 50% smaller. In some embodiments, the second height may be greater than the third height, such as from at least 10% to at most 50% greater.

In some embodiments, the second height is at least 10% greater than at least one of the first height and the third height, such as 20, 30, 40, or 50 percent greater. The first height and the third height may be equal. Alternatively, the first height and the third height may be different, for example the first height may be lower than the second height, such as from at least 10% to at most 50% smaller. In some embodiments, the first height may be greater than the third height, such as from at least 10% to at most 50% greater.

In some embodiments, the third height is at least 10% greater than at least one of the second height and the third height, such as 20, 30, 40, or 50 percent greater. The first height and the second height may be equal. Alternatively, the first height and the second height may be different, for example the first height may be lower than the second height, such as from at least 10% to at most 50% smaller. In some embodiments, the first height may be greater than the second height, such as from at least 10% to at most 50% greater.

In some embodiments, at least one of the first height, the second height, and the third height is from at least 100 nanometer to at most 5 mm, or from at least 100 nanometer to at most 200 nanometer, or from at least 200 nanometer to at most 500 nanometer, or from at least 500 nanometer to at most 1 micrometer, or from at least 1 micrometer to at most 2 micrometer, or from at least 2 micrometer to at most 5 micrometer, or from at least 5 micrometer to at most 10 micrometer, or from at least 10 micrometer to at most 20 micrometer, or from at least 20 micrometer to at most 50 micrometer, or from at least 50 micrometer to at most 100 micrometer, or from at least 100 micrometer to at most 200 micrometer, or from at least 200 micrometer to at most 500 micrometer, or from at least 500 micrometer to at most 1 millimeter, or from at least 1 millimeter to at most 2 millimeter, or from at least 2 millimeter to at most 5 millimeter.

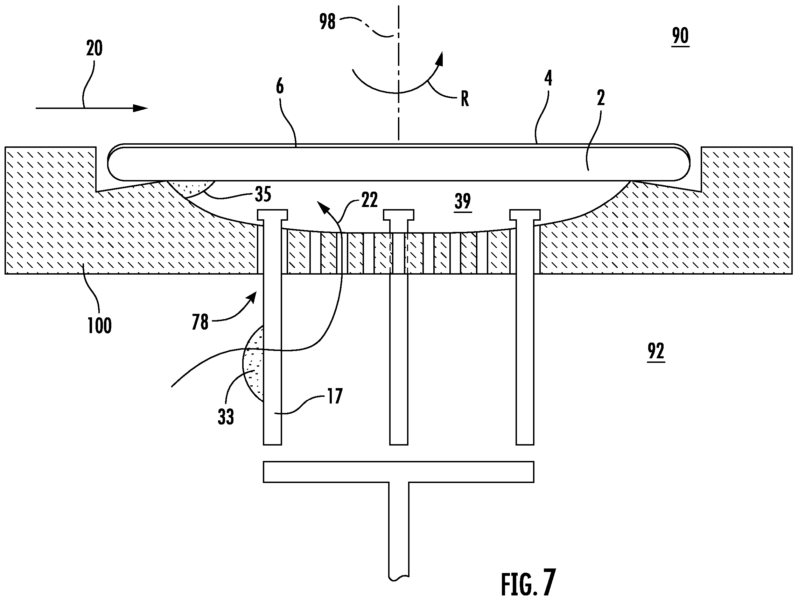

As shown in FIG. 7, material layer deposition on the substrate is accomplished by rotating the susceptor 100 (and the substrate 2) about the rotation axis 98 using the lift and rotate module 76 (shown in FIG. 3), heating the substrate 2 to a predetermined material layer deposition temperature using the upper lamp array 66 (shown in FIG. 3) and the lower lamp array 68 (shown in FIG. 3), and providing the material layer precursor gas 20 to the chamber arrangement 14 (shown in FIG. 1) using the gas delivery arrangement 12 (shown in FIG. 1). It is contemplated that the chamber body 62 flow the material layer precursor gas 20 across the top surface 6 of the substrate 2, that thermal and pressure conditions within the upper chamber 90 of the chamber body 62 cause the material layer 4 to deposit onto the top surface 6 of the substrate 2, and that the residual precursor and/or reaction products 26 (shown in FIG. 1) associated with the deposition be communicated to the exhaust arrangement 16 (shown in FIG. 1). Once the material layer 4 reaches a predetermined thickness, flow of the material layer precursor gas 20 to the chamber arrangement 14 by the gas delivery arrangement 12 ceases, rotation of the susceptor 100 by the lift and rotate module 76 ceases, and heating of the substrate 2 by the upper lamp array 66 and the lower lamp array 68 ceases.

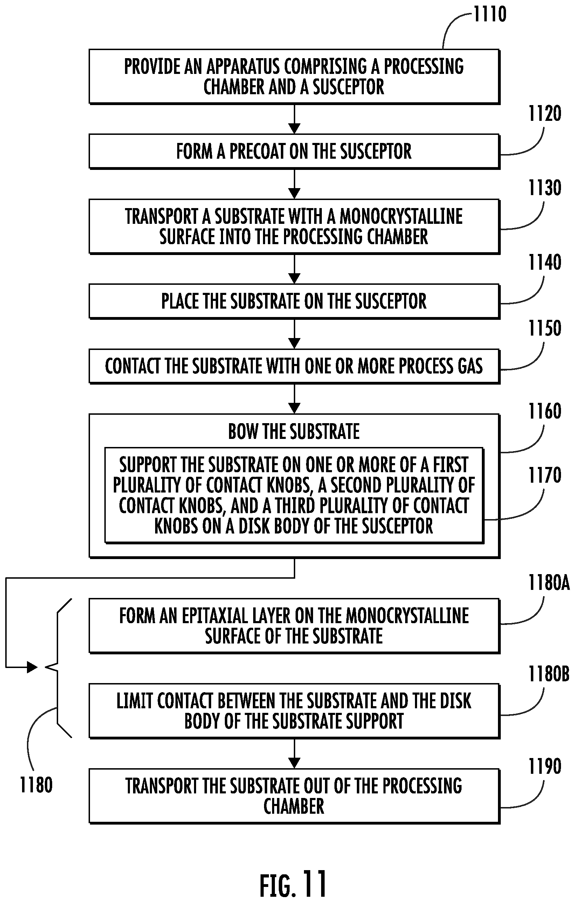

In some embodiments, and referring to Fig. 11, a susceptor as described herein can be employed in a method of forming an epitaxial layer. The method can comprise providing 1110 an apparatus that comprises processing chamber configured to accommodate a substrate. The apparatus further comprises a susceptor configured to support the substrate. The susceptor comprises an annular body that extends about a rotation axis. The annular body has a plurality of tang portions that extend radially inward toward the rotation axis. The susceptor further comprises a disk body with an upper surface that is seated on the tang portions of the annular body. The disk body has: a first plurality of contact knobs that are distributed circumferentially about the rotation axis on first circumference C1; a second plurality of contact knobs that are distributed circumferentially about the rotation on a second circumference C2; and a third plurality of contact knobs that are distributed circumferentially about the rotation axis on a third circumference C3. The second circumference is radially intermediate the first circumference and the third circumference to limit contact between a substrate seated on the disk body and the upper surface of the disk body. The method comprises forming 1120 a precoat on the susceptor. The method further comprises transporting 1130 a substrate with a monocrystalline surface into the processing chamber, for example while the processing chamber is at a temperature that is between 650 degrees Celsius and about 750 degrees Celsius. The method further comprises placing 1140 the substrate on the susceptor. The method further comprises contacting 1150 the substrate with one or more process gases. The method further comprises bowing 1160 the substrate and supporting 1170 the substrate on one or more of the first plurality of contact knobs, the second plurality of contact knobs, and the third plurality of contact knobs during forming 1180 of the epitaxial layer on the monocrystalline surface of the substrate. The method further comprises transporting 1190 the substrate out of the processing chamber, for example while the substrate is between about 650 degrees Celsius and about 750 degrees Celsius. In certain examples forming 1180 of the epitaxial layer may include forming 1180 the epitaxial layer at high temperature, for example between about 800 degrees Celsius and about 120 degrees Celsius, the relatively high load and unload temperature limiting time required to heat the substrate and/or increasing throughput of the processing chamber relative to processing chambers employing lower load and unload temperatures. Contact between the substrate and the disk body of the susceptor may be by support of the substrate on at least one of the first plurality of contact knobs, the second plurality of contact knobs, and the third plurality of contact knobs. Advantageously, the contact knobs minimize contact between the substrate and the upper surface of the disk body.

## Claims

1. A susceptor, comprising:
an annular body extending about a rotation axis and having a plurality of tang portions extending radially inward toward the rotation axis;
a disk body with an upper surface seated on the tang portions of the annular body, the disk body having:
a first plurality of contact knobs distributed circumferentially about the rotation axis on first circumference C1;
a second plurality of contact knobs distributed circumferentially about the rotation on a second circumference C2; and
a third plurality of contact knobs distributed circumferentially about the rotation axis on a third circumference C3;
wherein the second circumference is radially intermediate the first circumference and the third circumference to limit contact between a substrate seated on the disk body and the upper surface of the disk body.

2. The susceptor according to claim 1, wherein (C2-C1)/(C3-C1) equals from at least 0.1 to at most 0.9.

3. The susceptor according to claim 2, wherein (C2-C1)/(C3-C1) equals from at least 0.3 to at most 0.7.

4. The susceptor, according to claim 2 wherein (C2-C 1)/(C3-C 1) equals from at least 0.2 to at most 0.5.

5. The susceptor, according to claim 2 wherein (C2-C 1)/(C3-C 1) equals from at least 0.5 to at most 0.8.

6. The susceptor according to any one of claims 1-5, wherein the first plurality of contact knobs comprises a first surface, the second plurality of contact knobs comprises a second surface, and the third plurality of contact knobs comprise third surface.

7. The susceptor according to claim 6 ,wherein the first surface, the second surface, and the third surface comprise a refractory ceramic.

8. The susceptor according to claim 7, wherein the refractory ceramic comprises a semiconductor.

9. The susceptor according to claim 8, wherein the semiconductor comprises silicon carbide.

10. The susceptor according to claim 6, wherein at least one of the first surface, the second surface, and the third surface is honed.

11. The susceptor according to claim 6, wherein at all of the first surface, the second surface, and the third surface are honed.

12. The susceptor according to claim 6, wherein at all of the first surface, the second surface, and the third surface are unhoned.

13. The susceptor according to any one of the preceding claims, wherein the first plurality of contact knobs have a first height, wherein the second plurality of contact knobs have a second height, and wherein the third plurality of contact knobs have a third height.

14. The susceptor according to claim 13, wherein the first height, the second height, and the third height are equal within a margin of error of 10%.

15. The susceptor according to claim 13, wherein the first height is at least 10% greater than at least one of the second height and the third height.

16. The susceptor according to claim 13, wherein the second height is at least 10% greater than at least one of the first height and the third height.

17. The susceptor according to claim 13, wherein the third height is at least 10% greater than at least one of the second height and the third height.

18. The susceptor according to any one of the preceding claims, wherein the disk body comprises a ceramic coating.

19. The susceptor according to any one of the preceding claims, further comprising a silicon-containing precoat formed onto the first plurality of contact knobs, the second plurality of contact knobs, and the third plurality of contact knobs.

20. An apparatus for processing a substrate, the apparatus comprising:
a processing chamber configured to accommodate a substrate; and
a susceptor configured to support the substrate,
the susceptor comprising an annular body extending about a rotation axis and having a plurality of tang portions extending radially inward toward the rotation axis;
a disk body with an upper surface seated on the tang portions of the annular body, the disk body having:
a first plurality of contact knobs distributed circumferentially about the rotation axis on first circumference C1;
a second plurality of contact knobs distributed circumferentially about the rotation on a second circumference C2; and
a third plurality of contact knobs distributed circumferentially about the rotation axis on a third circumference C3;
wherein the second circumference is radially intermediate the first circumference and the third circumference to limit contact between a substrate seated on the disk body and the upper surface of the disk body.

21. A method of forming an epitaxial layer, the method comprising
providing an apparatus comprising: a processing chamber configured to accommodate a substrate; and a susceptor configured to support the substrate, the susceptor comprising an annular body extending about a rotation axis and having a plurality of tang portions extending radially inward toward the rotation axis; a disk body with an upper surface seated on the tang portions of the annular body, the disk body having: a first plurality of contact knobs distributed circumferentially about the rotation axis on first circumference C1; a second plurality of contact knobs distributed circumferentially about the rotation on a second circumference C2; and a third plurality of contact knobs distributed circumferentially about the rotation axis on a third circumference C3; wherein the second circumference is radially intermediate the first circumference and the third circumference to limit contact between a substrate seated on the disk body and the upper surface of the disk body;
placing the substrate on the susceptor, the substrate comprising a monocrystalline surface;
contacting the substrate with one or more process gases while the substrate is in the processing chamber;
forming an epitaxial layer onto the monocrystalline surface of the substrate with the one or more process gases;
wherein during at least one of placing the substrate on the susceptor, contacting the substrate with one or more process gases, and forming the epitaxial layer onto the substrate bows and is supported by at least one of the first plurality of contact knobs, the second plurality of contact knobs, and the third plurality of contact knobs; and
whereby supporting the substrate on one or more of the first plurality of contact knobs, the second plurality of contact knobs, and the third plurality of contact knobs limits contact between the substrate and the upper surface of the disk body.
